# EUROPEAN PATENT SPECIFICATION

(11) **EP 2 801 032 B1**
(45) Date of publication and mention of the grant of the patent: **01.01.2020**
(21) Application number: 12864332.7
(22) Date of filing: 04.01.2012
(51) Int. Cl.: G06F 13/14, G06F 12/00, G06F 15/80, G06F 13/16, G06F 3/06, G06F 13/42, G11C 13/00, G11C 14/00

(54) **BIMODAL FUNCTIONALITY BETWEEN COHERENT LINK AND MEMORY EXPANSION**
BIMODALE FUNKTIONALITÄT ZWISCHEN KOHÄRENTEN LINKS UND SPEICHERERWEITERUNG
FONCTIONNALITÉ BIMODALE ENTRE LIAISON COHÉRENTE ET EXTENSION DE MÉMOIRE

(43) Date of publication of application: 12.11.2014
(73) Proprietor: Intel Corporation, Santa Clara, CA 95054 (US)
(72) Inventor: CRETA, Kenneth C., Gig Harbor Washington 098332 (US); HORIHAN, Jason W., Hillsboro Oregon 97124 (US); BLANKENSHIP, Robert G., Tacoma Washington 98407 (US); CHENG, Kai, Portland Oregon 97229 (US)
(74) Representative: HGF Limited
(86) International application number: PCT/US2012/020175
(87) International publication number: WO 2013/103339

(56) References cited:
- WO-A1-2011/002437
- US-A1- 2006 277 355
- US-A1- 2009 177 853
- US-A1- 2011 072 193
- US-A1- 2011 113 115
- US-B1- 7 305 540
- US-B2- 7 600 091

## Description

### FIELD

The present disclosure generally relates to the field of electronics. More particularly, some embodiments relate to bimodal functionality between a coherent link and memory expansion.

### BACKGROUND

Computer systems are made up of components that may communicate with one another for various purposes. Links that interconnect computer components may provide a mechanism for transferring data and/or clock signals between the components. One such link is a QPI (Quick Path Interconnect) which is designed to interconnect various components such as processors and memory devices. However, current QPI system may not easily expand the amount of memory available through such links. Prior systems may have implemented dedicated memory buffer interfaces for the purpose of expanding the memory capacity and bandwidth to the microprocessor or chipset. However, the investment of these dedicated interfaces are high and not useful for systems which do not require this high amount of memory.

Reference is made to WO 2011/002437 A1, which discloses a system and method wherein a memory agent module to identify a memory command related to virtual memory pages associated with a memory blade and maintain and optimize cache coherency for such pages. The system and method also includes a memory module, operatively connected to the memory agent that includes a page cache used by the memory agent to manage the virtual memory page. Further, the system and method includes a transmission module to transmit the memory command to the memory blade, as well as data structures to facilitate the page migration between the compute blade's local memory and remote memory on the memory blade.

Reference is made to patent document US7305540, which discloses a data processing system with a host memory interface that can be used as a cache coherent as well as a cache non-coherent interface.

### BRIEF DESCRIPTION OF THE DRAWINGS

The detailed description is provided with reference to the accompanying figures. In the figures, the left-most digit(s) of a reference number identifies the figure in which the reference number first appears. The use of the same reference numbers in different figures indicates similar or identical items.

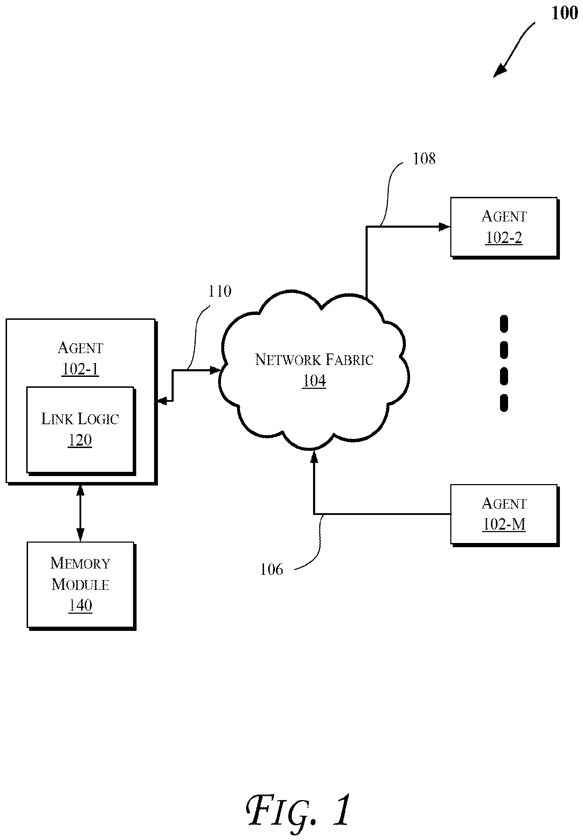

Figs. 1-5 illustrate block diagrams of embodiments of computing systems, which may be utilized to implement various embodiments discussed herein.

### DETAILED DESCRIPTION

Various aspects of embodiments of the invention may be performed using various means, such as integrated semiconductor circuits ("hardware"), computer-readable instructions organized into one or more programs ("software") or some combination of hardware and software. For the purposes of this disclosure reference to "logic" shall mean either hardware, software, or some combination thereof.

Some of the embodiments discussed herein may provide a buffered memory interface which includes a coherent interconnect (such as QPI). This provides platform flexibility that is absent from current systems. In an embodiment, an architecture is provided which scales easily for higher end computing systems (e.g., servers) that demand a buffered memory interface to enable very high DIMM (Dual Inline Memory Module) counts. As discussed herein, a buffered memory interface generally refers to providing a memory buffering logic between a memory controller and a memory module, or between a CPU die and a memory controller (which may be included in the CPU die in some embodiments as discussed herein). The combined coherent and buffered memory interface in turn allows for flexible expansion of memory capacity in systems with a coherent memory interface (such as QPI), which may be collectively referred to as QPMI (QuickPath Memory Interface).

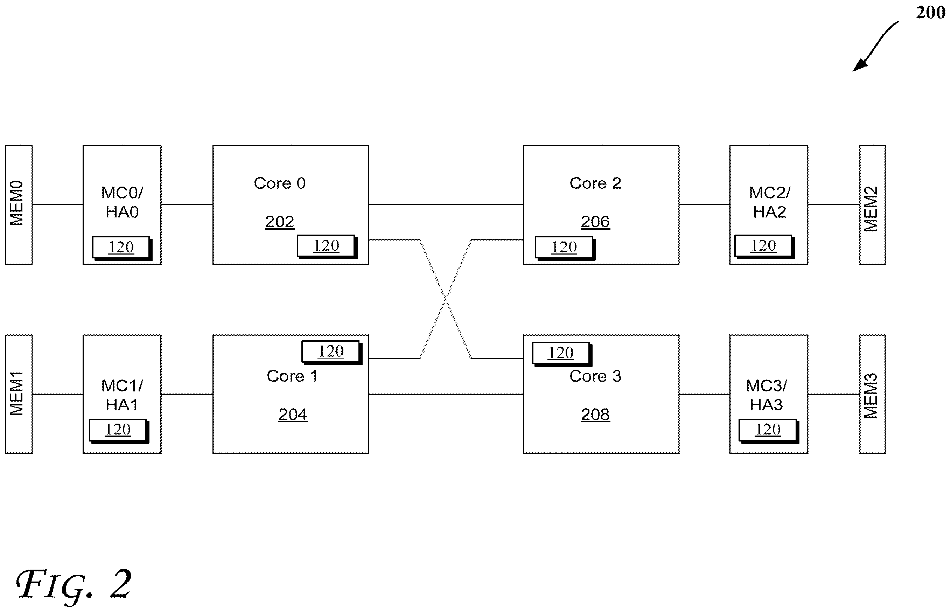

Various embodiments are discussed herein with reference to a computing system component, such as the components discussed herein, e.g., with reference to Figs. 1-2 and 4-5. More particularly, Fig. 1 illustrates a block diagram of a computing system 100, according to an embodiment of the invention. The system 100 may include one or more agents 102-1 through 102-M (collectively referred to herein as "agents 102" or more generally "agent 102"). In an embodiment, the agents 102 may be components of a computing system, such as the computing systems discussed with reference to Figs. 2 and 4-5.

As illustrated in Fig. 1, the agents 102 may communicate via a network fabric 104. In an embodiment, the network fabric 104 may include one or more interconnects (or interconnection networks) that communicate via a serial (e.g., point-to-point) link and/or a shared communication network. For example, some embodiments may facilitate component debug or validation on links that allow communication with fully buffered dual in-line memory modules (FBD), e.g., where the FBD link is a serial link for coupling memory modules to a host controller device (such as a processor or memory hub). Debug information may be transmitted from the FBD channel host such that the debug information may be observed along the channel by channel traffic trace capture tools (such as one or more logic analyzers).

In one embodiment, the system 100 may support a layered protocol scheme, which may include a physical layer, a link layer, a routing layer, a transport layer, and/or a protocol layer. The fabric 104 may further facilitate transmission of data (e.g., in form of packets) from one protocol (e.g., caching processor or caching aware memory controller) to another protocol for a point-to-point network. Also, in some embodiments, the network fabric 104 may provide communication that adheres to one or more cache coherent protocols.

Furthermore, as shown by the direction of arrows in Fig. 1, the agents 102 may transmit and/or receive data via the network fabric 104. Hence, some agents may utilize a unidirectional link while others may utilize a bidirectional link for communication. For instance, one or more agents (such as agent 102-M) may transmit data (e.g., via a unidirectional link 106), other agent(s) (such as agent 102-2) may receive data (e.g., via a unidirectional link 108), while some agent(s) (such as agent 102-1) may both transmit and receive data (e.g., via a bidirectional link 110).

Also, in accordance with an embodiment, one or more of the agents 102 may include a link logic 120 to provide a buffered memory interface to enable a bimodal link interface (e.g., to support both a buffered and coherent memory interface). As shown logic 120 may be coupled to one or more memory modules 140. In some embodiments, one or more components of a multi-agent system (such as processor core, chipset, input/output hub, memory controller, etc.) may include a logic 120 as will be further discussed with reference to the remaining figures.

More specifically, Fig. 2 is a block diagram of a computing system 200 in accordance with an embodiment. System 200 may include a plurality of sockets 202-208 (four shown but some embodiments may have more or less socket). Each socket may include a processor and a logic 120. In some embodiments, logic 120 may be present in one or more components of system 200 (such as those shown in Fig. 2). However, more or less logic 120 blocks may be present in a system depending on the implementation. Also, each socket may be coupled to the other sockets via a point-to-point (PtP) link, such as a Quick Path Interconnect (QPI). As discussed with respect the network fabric 104 of Fig. 1, each socket may be coupled to a local portion of system memory, e.g., formed of a plurality of Dual Inline Memory Modules (DIMMs) that may include dynamic random access memory (DRAM).

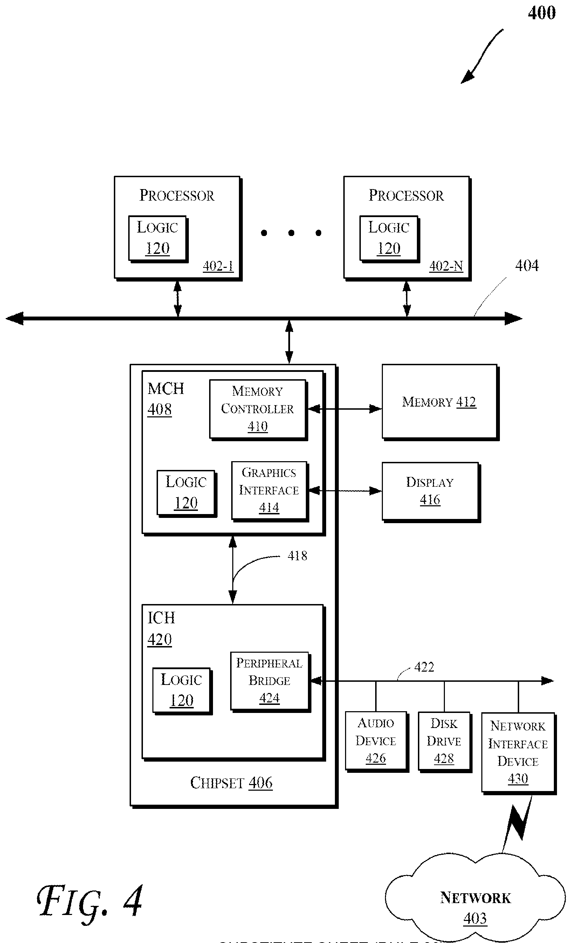

As shown in Fig. 2, each socket may be coupled to a memory controller (MC)/Home Agent (HA) (such as MC0/HA0 through MC3/HA3). The memory controllers may be coupled to a corresponding local memory (labeled as MEMO through MEM3), which may be the same as or similar to the memory 140 of Fig. 1 and/or a portion of system memory (such as memory 412 of Fig 4). In some embodiments, the memory controller (MC)/Home Agent (HA) (such as MC0/HA0 through MC3/HA3) may be the same or similar to agent 102-1 of Fig. 1 and the memory, labeled as MEMO through MEM3, may be the same or similar to memory discussed with reference to any of the figures herein. Generally, processing/caching agents may send requests to a home node for access to a memory address with which a corresponding "home agent" is associated. Also, in one embodiment, MEMO through MEM3 may be configured to mirror data, e.g., as master and slave. Also, one or more components of system 200 may be included on the same integrated circuit die in some embodiments.

Furthermore, one implementation (such as shown in Fig. 2) may be for a socket glueless configuration with mirroring. For example, data assigned to a memory controller (such as MC0/HA0) may be mirrored to another memory controller (such as MC3/HA3) over the PtP links.

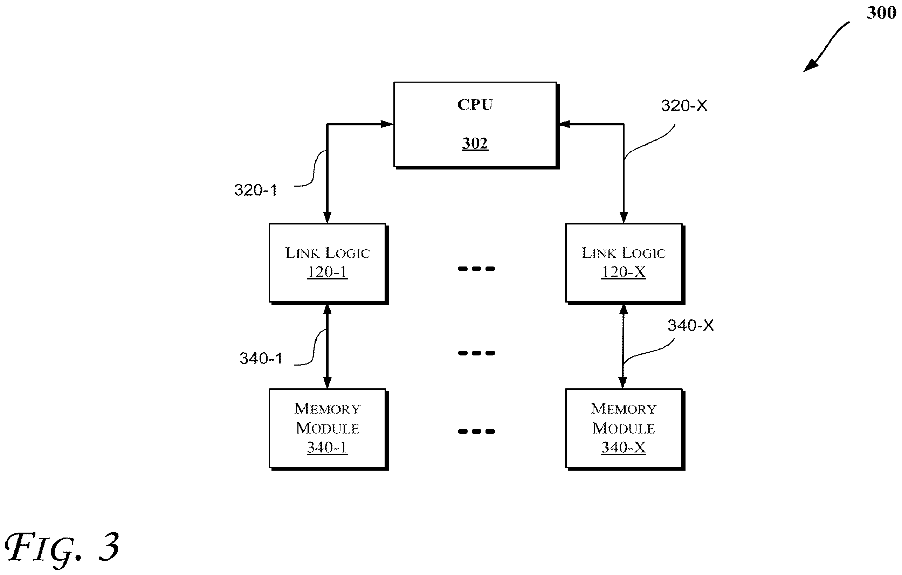

Fig. 3 illustrates a block diagram of portions of a computing system 300 with an interface which may either act as a coherent interface or a memory buffer interface, according to an embodiment. As shown a CPU (Central Processing Unit) 302 (which may be similar to or the same as processors discussed with reference to Figs. 4-5, for example) is coupled to one or more memory modules 340-1 through 340-X (which may be the same or similar to the memory module 140 of Fig. 1) via the link logic 120-1 through 120-X, respectively. In various embodiments, the CPU 302 may include logic to couple the CPU to one or more: coherent interconnects (e.g., via QPIs), DIMMs (e.g., via one or more memory controllers), PCIe devices (e.g., via integrated input/output hubs), etc. Also, interfaces 320-1 to 320-X may be QPMI compliant, while interfaces 340-1 to 340-X may be DDR (e.g., DDR2, DDR3, DDR4, etc.) interfaces.

In some embodiments, instead of creating a unique interface used only for memory buffering, QPI may be extended to add support for memory read/write commands (e.g., via the logic 120). In one embodiment, the interface provided by the logic 120 may be switched between a coherent interface or a memory buffer interface based on a single bit value (e.g., stored in a register, shared memory, non-volatile memory such as Phase Change Memory with Switch (PCMS), NAND memory, flash memory, etc.). For instance, an existing QPI interface may be put it into a QPMI mode. When in this mode, a memory buffering logic (e.g., logic 120), which implements the QPI physical layer, e.g., as a slave, accepts and responds to memory reads/writes operations/commands in accordance with an embodiment.

In an embodiment, the logic (120-1 through 120-X in Fig. 3) reuses the PHY/LINK layer of an existing interface (e.g., QPI). To the CPU 302, there is now a flexibility which enables each QPI interface to be programmed in coherent QPI mode (e.g., to couple to other CPUs or node controllers) or QPMI mode to enable memory expansion. So, in one embodiment, instead of memory buffers, the interfaces may be modified into a fully coherent mode for other CPUs or coherent accelerators.

Fig. 4 illustrates a block diagram of a computing system 400 in accordance with an embodiment of the invention. The computing system 400 may include one or more central processing unit(s) (CPUs) 402-1 through 402-N or processors (collectively referred to herein as "processors 402" or more generally "processor 402") that communicate via an interconnection network (or bus) 404. The processors 402 may include a general purpose processor, a network processor (that processes data communicated over a computer network 403), or other types of a processor (including a reduced instruction set computer (RISC) processor or a complex instruction set computer (CISC)). Moreover, the processors 402 may have a single or multiple core design. The processors 402 with a multiple core design may integrate different types of processor cores on the same integrated circuit (IC) die. Also, the processors 402 with a multiple core design may be implemented as symmetrical or asymmetrical multiprocessors. Also, the operations discussed with reference to Figs. 1-3 may be performed by one or more components of the system 400. In some embodiments, the processors 402 may be the same or similar to the processors 202-208 of Fig. 2. Furthermore, the processors 402 (or other components of the system 400) may include the logic 120.

A chipset 406 may also communicate with the interconnection network 404. The chipset 406 may include a memory controller hub (MCH) 408. The MCH 408 may include a memory controller 410 that communicates with a memory 412. The memory 412 may be the same as or similar to the memory 140 of Fig. 1. The memory 412 may store data, including sequences of instructions that are executed by the CPU 402, or any other device included in the computing system 400. For example, the memory 412 may store data corresponding to an operation system (OS). In one embodiment of the invention, the memory 412 may include one or more volatile storage (or memory) devices such as random access memory (RAM), dynamic RAM (DRAM), synchronous DRAM (SDRAM), static RAM (SRAM), or other types of storage devices. Nonvolatile memory may also be utilized such as a hard disk. Additional devices may communicate via the interconnection network 404, such as multiple CPUs and/or multiple system memories.

Additionally, one or more of the processors 402 may have access to one or more caches (which may include private and/or shared caches in various embodiments) and associated cache controllers (not shown). The cache(s) may adhere to one or more cache coherent protocols. The cache(s) may store data (e.g., including instructions) that are utilized by one or more components of the system 400. For example, the cache may locally cache data stored in a memory 412 for faster access by the components of the processors 402. In an embodiment, the cache (that may be shared) may include a mid-level cache and/or a last level cache (LLC). Also, each processor 402 may include a level 1 (LI) cache. Various components of the processors 402 may communicate with the cache directly, through a bus or interconnection network, and/or a memory controller or hub. Also, each of the processors 402 (or each core present in the processors 402) may include the logic 120 in some embodiments.

The MCH 408 may also include a graphics interface 414 that communicates with a display device 416, e.g., via a graphics accelerator. In one embodiment of the invention, the graphics interface 414 may communicate with the graphics accelerator via an accelerated graphics port (AGP). In an embodiment of the invention, the display 416 (such as a flat panel display) may communicate with the graphics interface 414 through, for example, a signal converter that translates a digital representation of an image stored in a storage device such as video memory or system memory into display signals that are interpreted and displayed by the display 416. The display signals produced by the display device may pass through various control devices before being interpreted by and subsequently displayed on the display 416.

A hub interface 418 may allow the MCH 408 and an input/output control hub (ICH) 420 to communicate. The ICH 420 may provide an interface to I/O devices that communicate with the computing system 400. The ICH 420 may communicate with a bus 422 through a peripheral bridge (or controller) 424, such as a peripheral component interconnect (PCI) bridge, a universal serial bus (USB) controller, or other types of peripheral bridges or controllers. The bridge 424 may provide a data path between the CPU 402 and peripheral devices. Other types of topologies may be utilized. Also, multiple buses may communicate with the ICH 420, e.g., through multiple bridges or controllers. Moreover, other peripherals in communication with the ICH 420 may include, in various embodiments of the invention, integrated drive electronics (IDE) or small computer system interface (SCSI) hard drive(s), USB port(s), a keyboard, a mouse, parallel port(s), serial port(s), floppy disk drive(s), digital output support (e.g., digital video interface (DVI)), or other devices.

The bus 422 may communicate with an audio device 426, one or more disk drive(s) 428, and a network interface device 430 (which is in communication with the computer network 403). Other devices may communicate via the bus 422. Also, various components (such as the network interface device 430) may communicate with the MCH 408 in some embodiments of the invention. In addition, the processor 402 and one or more components of the MCH 408 may be combined to form a single chip.

Furthermore, the computing system 400 may include volatile and/or nonvolatile memory (or storage). For example, nonvolatile memory may include one or more of the following: read-only memory (ROM), programmable ROM (PROM), erasable PROM (EPROM), electrically EPROM (EEPROM), a disk drive (e.g., 428), a floppy disk, a compact disk ROM (CD-ROM), a digital versatile disk (DVD), flash memory, a magneto-optical disk, or other types of nonvolatile machine-readable media that are capable of storing electronic data (e.g., including instructions).

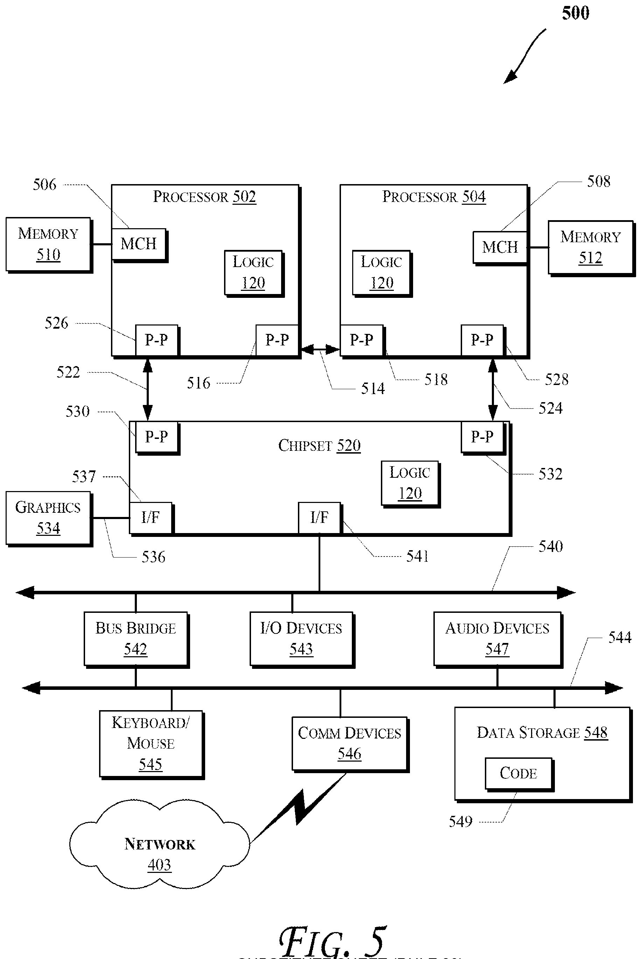

Fig. 5 illustrates a computing system 500 that is arranged in a point-to-point (PtP) configuration, according to an embodiment of the invention. In particular, Fig. 5 shows a system where processors, memory, and input/output devices are interconnected by a number of point-to-point interfaces. The operations discussed with reference to Figs. 1-4 may be performed by one or more components of the system 500.

As illustrated in Fig. 5, the system 500 may include several processors, of which only two, processors 502 and 504 are shown for clarity. The processors 502 and 504 may each include a local memory controller hub (MCH) 506 and 508 to enable communication with memories 510 and 512. The memories 510 and/or 512 may store various data such as those discussed with reference to the memory 412 of Fig. 4. As shown in Fig. 5, the processors 502 and 504 may also include the cache(s) discussed with reference to Fig. 4.

In an embodiment, the processors 502 and 504 may be one of the processors 402 discussed with reference to Fig. 4. The processors 502 and 504 may exchange data via a point-to-point (PtP) interface 514 using PtP interface circuits 516 and 518, respectively. Also, the processors 502 and 504 may each exchange data with a chipset 520 via individual PtP interfaces 522 and 524 using point-to-point interface circuits 526, 528, 530, and 532. The chipset 520 may further exchange data with a high-performance graphics circuit 534 via a high-performance graphics interface 536, e.g., using a PtP interface circuit 537.

At least one embodiment of the invention may be provided within the processors 502 and 504 or chipset 520. For example, the logic 120 may be provided within the processors 502 and 504 (or within each core of the processors 502 and/or 504). Other embodiments of the invention, however, may exist in other circuits, logic units, or devices within the system 500 of Fig. 5. Furthermore, other embodiments of the invention may be distributed throughout several circuits, logic units, or devices illustrated in Fig. 5.

The chipset 520 may communicate with a bus 540 using a PtP interface circuit 541. The bus 540 may have one or more devices that communicate with it, such as a bus bridge 542 and I/O devices 543. Via a bus 544, the bus bridge 542 may communicate with other devices such as a keyboard/mouse 545, communication devices 546 (such as modems, network interface devices, or other communication devices that may communicate with the computer network 403), audio I/O device, and/or a data storage device 548. The data storage device 548 may store code 549 that may be executed by the processors 502 and/or 504.

In various embodiments of the invention, the operations discussed herein, e.g., with reference to Figs. 1-5, may be implemented as hardware (e.g., circuitry), software, firmware, microcode, or combinations thereof, which may be provided as a computer program product, e.g., including a (e.g., non-transitory) machine-readable or (e.g., non-transitory) computer-readable medium having stored thereon instructions (or software procedures) used to program a computer to perform a process discussed herein. Also, the term "logic" may include, by way of example, software, hardware, or combinations of software and hardware. The machine-readable medium may include a storage device such as those discussed with respect to Figs. 1-5. Additionally, such computer-readable media may be downloaded as a computer program product, wherein the program may be transferred from a remote computer (e.g., a server) to a requesting computer (e.g., a client) by way of data signals transmitted via a carrier wave or other propagation medium via a communication link (e.g., a bus, a modem, or a network connection).

## Claims

1. A processor (302) comprising:
logic (120) to provide a first interface (320-1) to couple the processor to one or more agents via a coherent interconnect and alternatively to couple the processor to one or more Dual Inline Memory Modules 'DIMMs' (340-1);
wherein the one or more agents comprises one of: a processor core, a chipset, an input/output hub, or a memory controller; and wherein the interface provided by the logic may be switched between a coherent interface mode and a memory buffer interface mode based on a value of a single bit.

2. The processor of claim 1, wherein the single bit is to be stored in one or more of: a register, a shared memory, or a non-volatile memory, optionally wherein the non-volatile memory is to comprise one of: a Phase Change Memory with Switch 'PCMS', a NAND memory, or a flash memory.

3. The processor of claim 1, wherein the logic to couple the processor to the one or more DIMMs is coupled to the processor via the coherent interconnect.

4. The processor of claim 1, wherein the coherent interconnect is to comprise a Quick Path Interconnect 'QPI'.

5. The processor of claim 1, wherein the coherent interconnect is to comprise a point-to-point interconnect.

6. The processor of claim 1, wherein the processor is to comprise a plurality of processor cores or a plurality of sockets.

7. The processor of claim 1, wherein one or more of the one or more agents and the logic are on a same integrated circuit chip.

8. A method comprising:
coupling, via an interface of a first agent provided by a logic (120), the first agent (302) to a second agent via a coherent interconnect, wherein the second agent comprises one of: a processor core, a chipset, an input/output hub, or a memory controller; and alternatively coupling the first agent to one or more Dual Inline Memory Modules 'DIMMs' (340-1) via the interface provided by the logic,
wherein the interface provided by the logic may be switched, based on a value of a single bit, between a coherent interface mode in which the coupling uses the interface as the coherent interconnect and a memory buffer interface mode in which the coupling connects the first agent to the one or more DIMMs to enable memory expansion.

9. The method of claim 8, wherein the first agent is to comprise the logic.

10. The method of claim 8, further comprising storing the single bit in one or more of: a register, a shared memory, or a non-volatile memory.

11. The method of claim 10, wherein the non-volatile memory comprises one of: a Phase Change Memory with Switch 'PCMS', a NAND memory, or a flash memory.

12. The method of claim 8, further comprising coupling the logic to the first agent via the coherent interconnect.

13. Machine-readable storage including machine-readable instructions, when executed, to implement a method as set forth in any preceding claim.

## Patentansprüche

1. Prozessor (302), umfassend:
Logik (120) zum Bereitstellen einer ersten Schnittstelle (320-1), um den Prozessor mit einem oder mehreren Agenten über ein kohärentes Interconnect zu koppeln und alternativ den Prozessor mit einem oder mehreren "DIMM"-Modulen (Dual Inline Memory Modules, zweireihige Speichermodule) (340-1) zu koppeln;
wobei die ein oder mehreren Agenten eines der folgenden umfassen: einen Prozessorkern, einen Chipsatz, einen Eingabe-/Ausgabe-Knoten oder eine Speichersteuerung; und wobei die durch die Logik bereitgestellte Schnittstelle zwischen einer Betriebsart als kohärente Schnittstelle und einer Betriebsart als Speicherpufferschnittstelle umgeschaltet werden kann, basierend auf dem Wert eines einzelnen Bits.

2. Prozessor nach Anspruch 1, wobei das einzelne Bit in einem oder mehreren der folgenden gespeichert werden soll:
einem Register, einem gemeinsamen Speicher oder einem nichtflüchtigen Speicher, wobei der nichtflüchtige Speicher optional eines der folgenden umfassen soll: einen "PCMS" (Phase Change Memory with Switch, Phasenwechselspeicher mit Schalter), einen NAND-Speicher oder einen Flash-Speicher.

3. Prozessor nach Anspruch 1, wobei die Logik zum Koppeln des Prozessors mit den ein oder mehreren DIMMs mit dem Prozessor über das kohärente Interconnect gekoppelt ist.

4. Prozessor nach Anspruch 1, wobei das kohärente Interconnect ein "QPI" (QuickPath Interconnect) umfassen soll.

5. Prozessor nach Anspruch 1, wobei das kohärente Interconnect ein Punkt-zu-Punkt-Interconnect umfassen soll.

6. Prozessor nach Anspruch 1, wobei der Prozessor mehrere Prozessorkerne oder mehrere Steckplätze umfassen soll.

7. Prozessor nach Anspruch 1, wobei sich einer oder mehrere der ein oder mehreren Agenten und die Logik auf ein und demselben IC (Integrated Circuit , integrierte Schaltung)-Chip befinden.

8. Verfahren, umfassend:
Koppeln, über eine durch eine Logik (120) bereitgestellte Schnittstelle eines ersten Agenten, des ersten Agenten (302) mit einem zweiten Agenten über ein kohärentes Interconnect, wobei der zweite Agent eines der folgenden umfasst: einen Prozessorkern, einen Chipsatz, einen Eingabe-/Ausgabe-Knoten oder eine Speichersteuerung; und alternativ
Koppeln des ersten Agenten mit einem oder mehreren "DIMMs" (Dual Inline Memory Modulen) (340-1) über die durch die Logik bereitgestellte Schnittstelle,
wobei die durch die Logik bereitgestellte Schnittstelle, basierend auf dem Wert eines einzelnen Bits, zwischen einer Betriebsart als kohärente Schnittstelle, in der zur Kopplung die Schnittstelle als das kohärente Interconnect genutzt wird, und einer Betriebsart als Speicherpufferschnittstelle, in der die Kopplung den ersten Agenten mit den ein oder mehreren DIMMs verbindet, um eine Erweiterung des Speichers zu ermöglichen, umgeschaltet werden kann.

9. Verfahren nach Anspruch 8, wobei der erste Agent die Logik umfassen soll.

10. Verfahren nach Anspruch 8, ferner umfassend, das einzelne Bit in einem oder mehreren der folgenden zu speichern: einem Register, einem gemeinsamen Speicher oder einem nichtflüchtigen Speicher.

11. Verfahren nach Anspruch 10, wobei der nichtflüchtige Speicher eines der folgenden umfasst:
einen "PCMS" (Phase Change Memory with Switch), einen NAND-Speicher oder einen Flash-Speicher.

12. Verfahren nach Anspruch 8, ferner umfassend, die Logik mit dem ersten Agenten über das kohärente Interconnect zu koppeln.

13. Maschinenlesbarer Speicher, der maschinenlesbare Anweisungen enthält, die bei Ausführung ein Verfahren nach einem der vorstehenden Ansprüche implementieren.

## Revendications

1. Processeur (302) comprenant :
une logique (120) pour fournir une première interface (320-1) afin de coupler le processeur à un ou plusieurs agents par l'intermédiaire d'une interconnexion cohérente et en variante coupler le processeur à un ou plusieurs modules de mémoire à double rangée de broches 'DIMM' (340-1) ;
dans lequel les un ou plusieurs agents comprennent un : d'un cœur de processeur, d'un jeu de puces, d'un concentrateur d'entrée/sortie, ou d'un contrôleur de mémoire ; et dans lequel l'interface fournie par la logique peut être commutée entre un mode d'interface cohérent et un mode d'interface de tampon mémoire en fonction d'une valeur d'un bit unique.

2. Processeur selon la revendication 1, dans lequel le bit unique est destiné à être mémorisé dans un ou plusieurs : d'un registre, d'une mémoire partagée, ou d'une mémoire rémanente, facultativement dans lequel la mémoire rémanente comprend une : d'une mémoire à changement de phase avec commutation 'PCMS', d'une mémoire NON ET ou d'une mémoire flash.

3. Processeur selon la revendication 1, dans lequel la logique pour coupler le processeur aux un ou plusieurs DIMM est couplée au processeur par l'intermédiaire de l'interconnexion cohérente.

4. Processeur selon la revendication 1, dans lequel l'interconnexion cohérente est destinée à comprendre une interconnexion à chemin rapide 'QPI'.

5. Processeur selon la revendication 1, dans lequel l'interconnexion cohérente est destinée à comprendre une interconnexion point à point.

6. Processeur selon la revendication 1, le processeur étant destiné à comprendre une pluralité de cœurs de processeur ou une pluralité de connecteurs logiciels.

7. Processeur selon la revendication 1, dans lequel un ou plusieurs des un ou plusieurs agents et la logique se trouvent sur une même puce de circuit intégré.

8. Procédé comprenant :
le couplage, par l'intermédiaire d'une interface d'un premier agent fournie par une logique (120), du premier agent (302) à un second agent par l'intermédiaire d'une interconnexion cohérente, dans lequel le second agent comprend un : d'un cœur de processeur, d'un jeu de puces, d'un concentrateur d'entrée/sortie, ou d'un contrôleur de mémoire ; et en variante
le couplage du premier agent à un ou plusieurs modules de mémoire à double rangée de broches 'DIMM' (40-1) par l'intermédiaire de l'interface fournie par la logique,
dans lequel l'interface fournie par la logique peut être commutée entre un mode d'interface cohérent dans lequel le couplage utilise l'interface comme l'interconnexion cohérente et un mode d'interface de tampon mémoire dans lequel le couplage connecte le premier agent aux un ou plusieurs DIMM pour permettre une expansion de mémoire.

9. Procédé selon la revendication 8, dans lequel le premier agent est destiné à comprendre la logique.

10. Procédé selon la revendication 8, comprenant en outre la mémorisation du bit unique dans un ou plusieurs d'un registre, d'une mémoire partagée ou d'une mémoire rémanente.

11. Procédé selon la revendication 10, dans lequel la mémoire rémanente comprend une : d'une mémoire à changement de phase avec commutation 'PCMS', d'une mémoire NON ET ou d'une mémoire flash.

12. Procédé selon la revendication 8, comprenant en outre le couplage de la logique au premier agent par l'intermédiaire de l'interconnexion cohérente.

13. Mémoire lisible par machine comportant des instructions lisibles par machine qui, à leur exécution, mettent en œuvre un procédé tel qu'exposé dans n'importe quelle revendication précédente.
